# EUROPEAN PATENT APPLICATION

(11) **EP 4 429 110 A1**
(43) Date of publication of application: **11.09.2024**
(21) Application number: 23160200.4
(22) Date of filing: 06.03.2023
(51) Int. Cl.: H03K 17/06, H03K 17/082, H03K 17/18, H01L 27/02

(54) **HIGH VOLTAGE SEMICONDUCTOR DEVICE WITH DATA TRANSMISSION FROM A HIGH VOLTAGE DOMAIN TO A LOW VOLTAGE DOMAIN**

(71) Applicant: Infineon Technologies Austria AG, 9500 Villach (AT)
(72) Inventor: RUDOLF, Ralf, 01097 Dresden (DE); BOGUSZEWICZ, Remigiusz Viktor, 45276 Essen (DE); PRIEFERT, Dirk, 47445 Moers (DE)
(74) Representative: Müller Hoffmann & Partner

(57) **Abstract**

A gate driver circuit includes a low side part (100) and a high side part (200). The low side part (100) outputs a first gate drive signal between a first gate output and a first reference potential (VSS). The high side part (200) generates a high side data signal and outputs a second gate drive signal between a second gate output and a second reference potential (VS). A p-channel junction field effect transistor structure (300) passes the high side data signal to the low side part (100) .

## Description

### TECHNICAL FIELD

Examples of the preset disclosure relate to a high voltage semiconductor device having a high voltage domain and a low voltage domain. In particular, the present disclosure can relate to gate driver circuits with a signal path that passes a data signal originating in the high voltage domain to the low voltage domain.

### BACKGROUND

HV (high-voltage) semiconductor devices in CMOS technology (complementary metal oxide semiconductors) form or include an interface between standard CMOS devices with input voltages below 5V on the one hand and industrial or consumer circuits operating at voltages above 30V on the other hand. Applications for such HV semiconductor devices exist in robotics, the automotive industry and as drivers for MEMS (micro electromechanical systems). Typically, most of the signal processing is done at low operating voltage in a CMOS part and only the output signal interface to and/or the input signal interface operates at higher signal levels and/or requires higher current driving and sinking capability. An example of such a HV semiconductor device is a gate driver circuit that enables a microcontroller or DSP (digital signal processor) to efficiently turn on and off power semiconductor switches. Signals containing information about the operation of the power semiconductor switches can be fed back to the CMOS part from the interfaces to the power semiconductor switches.

There is a constant need to further improve data exchange between different parts of a high voltage semiconductor device such as a gate driver circuit with little additional effort.

### SUMMARY

The general invention relates to a high voltage semiconductor device having a high voltage domain and a low voltage domain. Elements interfacing between the high voltage domain and the low voltage domain can be susceptible to high electric fields. Elements that are less susceptible to high voltage interference can provide more reliable data transmission from the high voltage domain to the low voltage domain. One more specific example for such a high voltage semiconductor device is a gate driver device having a high side part (as the high voltage domain) and a low side part (as the low voltage domain) .

A high voltage semiconductor device in accordance with the general invention of the pertinent disclosure includes a low voltage domain at a first reference potential. A high voltage domain is configured to generate a high voltage data signal at a second reference potential. A junction transistor device is configured to pass the high voltage data signal from the high voltage domain to the low voltage domain.

More specific embodiments of the present disclosure relate to a gate driver device having a high side part and a low side part. Elements interfacing between the high side part and the low side part can be susceptible to high electric fields. Elements that are less susceptible to high voltage interference can provide more reliable data transmission from the high side part to the low side portion.

A gate driver circuit in accordance with the embodiments of the pertinent disclosure includes a low side part configured to output a first gate drive signal between a first gate output and a first reference potential. A high side partis configured to generate a high side data signal and to output a second gate drive signal between a second gate output and a second reference potential. A junction transistor device passes the high side data signal to the low side portion.

Compared to transformers and optocouplers, transistor devices are comparatively easy to integrate into a gate driver. Compared to IGFETs (insulated gate field effect transistors) like MOSFETs (metal oxide semiconductor field effect transistors), junction transistor devices can be designed in a way to be susceptible to high voltage interference to only a comparatively small extent at low effort.

Those skilled in the art will recognize additional features and advantages upon reading the following detailed description and on viewing the accompanying drawings.

### BRIEF DESCRIPTION OF THE DRAWINGS

The accompanying drawings are included to provide a further understanding of the embodiments and are incorporated in and constitute a part of this specification. The drawings illustrate embodiments of a gate driver circuit and together with the description serve to explain principles of the embodiments. Further embodiments are described in the following detailed description and the claims. Features of the various illustrated embodiments may be combined with each other.
FIG. 1 is a schematic circuit diagram of a switching assembly having a high side switch, a low side switch, and a gate driver circuit with a junction transistor device for passing a data signal from a high side part to a low side part in accordance with an embodiment.
FIG. 2 is a schematic circuit diagram of a switching assembly including a gate driver circuit with a pnp BJT for passing a data signal from a high side part to a low side part in accordance with an embodiment.
FIG. 3 is a schematic circuit diagram of a switching assembly including a gate driver circuit with a pJFET for passing a data signal from a high side part to a low side part in accordance with an embodiment.
FIG. 4 is a schematic circuit diagram of a switching assembly including a gate driver circuit with a pJFET for passing a data signal from a high side part to a low side part in accordance with an embodiment having a reverse diode connected in series with the pJFET.
FIG. 5 is a schematic block diagram of a gate driver circuit with two pJFETs for passing a differential data signal from a high side part to a low side part in accordance with an embodiment.
FIG. 6 is a schematic block diagram of a further gate driver circuit with two pJFETs for passing data signals from a high side part to a low side part in accordance with an embodiment.
FIG. 7A and FIG. 7B show a schematic vertical cross-sectional view and a corresponding schematic horizontal cross-sectional view of a gate driver circuit in accordance with an embodiment having a pJFET.
FIG. 8A and FIG. 8B show a schematic vertical cross-sectional view and a corresponding plan view of a gate driver circuit formed in SOI (silicon-on-insulator) technology in accordance with an embodiment
FIG. 9 shows a schematic plan view of a gate driver circuit as illustrated in FIG. 6 in accordance with an embodiment.
FIG. 10A and FIG. 10B show a schematic vertical cross-sectional view and a corresponding horizontal cross-sectional view of a gate driver circuit in accordance with an embodiment related to a pJFET with compensation regions.
FIG. 11A and FIG. 11B show a schematic vertical cross-sectional view and a corresponding horizontal cross-sectional view of a gate driver circuit in accordance with an embodiment related to a pJFET with n+ doped emitter region.
FIG. 12A and FIG. 12B show a schematic vertical cross-sectional view and a corresponding horizontal cross-sectional view of a gate driver circuit in accordance with an embodiment related to a combination of a pJFET with a reverse diode.
FIG. 13A and FIG. 13B show a schematic vertical cross-sectional view and a corresponding horizontal cross-sectional view of a gate driver circuit in accordance with an embodiment related to combination of a reverse diode and a pJFET with n+ doped emitter region.
FIG. 14 is a schematic plan view of a portion of a gate driver circuit with a pJFET formed over an inner termination structure 490 in accordance with an embodiment.
FIG. 15 is a schematic plan view of a portion of a gate driver circuit with a pJFET and an emitter region in accordance with an embodiment.
FIG. 16 shows a schematic vertical cross-sectional view of a portion of a gate driver circuit with a pJFET and shield rings in accordance with an embodiment.
FIG. 17 shows a schematic vertical cross-sectional view of a portion of a gate driver circuit with a pJFET, shield rings, and metal field rings in accordance with an embodiment.
FIG. 18 is a perspective view of a portion of a pJFET oriented to the low side part in accordance with an embodiment.
FIG. 19 is a perspective view of a portion of the pJFET of FIG. 18 oriented to the high side part in accordance with an embodiment.

### DETAILED DESCRIPTION

In the following detailed description, reference is made to the accompanying drawings, which form a part hereof and in which are shown by way of illustrations specific embodiments in which a gate driver device may be practiced. Other embodiments may be utilized and structural or logical changes may be made without departing from the scope of the present disclosure. For example, features illustrated or described for one embodiment can be used on or in conjunction with other embodiments to yield yet a further embodiment. It is intended that the present disclosure includes such modifications and variations. The examples are described using specific language, which should not be construed as limiting the scope of the appending claims. The drawings are not scaled and are for illustrative purposes only. Corresponding elements are designated by the same reference signs in the different drawings if not stated otherwise.

The terms "having", "containing", "including", "comprising" and the like are open, and the terms indicate the presence of stated structures, elements or features but do not preclude the presence of additional elements or features. The articles "a", "an" and "the" are intended to include the plural as well as the singular, unless the context clearly indicates otherwise.

The term "electrically connected" describes a permanent low-resistive ohmic connection between electrically connected elements, for example a direct contact between the concerned elements or a low-resistive connection via a metal and/or heavily doped semiconductor material.

The term "power semiconductor device" refers to semiconductor devices with a high voltage blocking capability of at least 30 V, for example 48 V, 100 V, 600 V, 1.6 kV, 3.3 kV or more and with a nominal on-state current or forward current of at least 200 mA, for example 1 A, 10 A or more.

MOSFETs (metal oxide semiconductor field effect transistor) are voltage-controlled devices and include all types of IGFETs (insulated gate field effect transistors) with gate electrodes based on doped semiconductor material and/or metal and with gate dielectrics made of oxide and/or dielectric materials other than oxides.

An ohmic contact describes a non-rectifying electrical junction between two conductors, e.g., between a semiconductor material and a metal. The ohmic contact has a linear or approximately linear current-voltage (I-V) curve in the first and third quadrant of the I-V diagram as with Ohm's law.

Ranges given for physical dimensions include the boundary values. For example, a range for a parameter y from a to b reads as a ≤ y ≤ b. The same holds for ranges with one boundary value like "at most" and "at least".

The term "on" is not to be construed as meaning only "directly on". Rather, if one element is positioned "on" another element (e.g., a layer is "on" another layer or "on" a substrate), a further component (e.g., a further layer) may be positioned between the two elements (e.g., a further layer may be positioned between a layer and a substrate if the layer is "on" said substrate).

Two adjoining doping regions in a semiconductor layer form a semiconductor junction. Two adjoining doping regions of the same conductivity type and with different dopant concentrations form a unipolar junction, e.g., an n/n+ or p/p+ junction along a boundary surface between the two doping regions. At the unipolar junction a dopant concentration profile orthogonal to the unipolar junction may show a step or a turning point, at which the dopant concentration profile changes from being concave to convex, or vice versa. Two adjoining doping regions of complementary conductivity form a pn junction.

The Figures illustrate relative doping concentrations by indicating "-" or "+" next to the doping type "n" or "p" . For example, "n-" means a doping concentration which is lower than the doping concentration of an "n"-doping region while an "n+"-doping region has a higher doping concentration than an "n"-doping region. Doping regions of the same relative doping concentration do not necessarily have the same absolute doping concentration. For example, two different "n"-doping regions may have the same or different absolute doping concentrations.

The present disclosure concerns a high voltage semiconductor device that includes a low side part and a high side part. The high voltage semiconductor device can be a gate driver device. The low side part outputs a first gate drive signal between a first gate output and a first reference potential VSS. The high side part outputs a second gate drive signal between a second gate output and a second reference potential VS. The high side part also generates a high side data signal. A p-type junction transistor structure passes the high side data signal to the low side part.

The low side part includes electric circuits of a low voltage domain. The low voltage domain outputs the first gate drive signal and may further include electric circuits of a CMOS interface for communicating with standard CMOS devices having input voltages below 5V. The electric circuits for the CMOS interface and the electric circuits for driving the first gate drive signal may be isolated from each other or may be parts of a one-part voltage domain.

The first gate drive signal output by the low side part may be capable of driving a gate of a low side switch of an electronic half bridge. The second gate drive signal output by the high side part may be capable of driving a high side switch of the same half bridge. The half bridge may be part of a H-bridge that switches the polarity of a voltage applied to a load.

The high side data signal may be a signal indicating a fault condition. For example, a half bridge includes IGBTs as low side switch and high side switch, and the high side data signal may indicate a desaturation of the high side switch in case a short-circuit condition occurs.

The p-type junction transistor structure is integrated in the gate driver circuit and is formed in and on the same semiconductor die as the elements of the low side part and the high side part. The junction transistor structure forms a signal gate facilitating data transfer from the high side part to the low side part. The junction transistor structure can be formed in a way that no additional chip area is required, and the additional process costs are low.

The junction transistor structure includes a doped control region and a semiconductor current path for a controlled current. A charge carrier flow along the semiconductor current path is controlled by a voltage applied to the doped control region and/or a current flowing into or out of the doped control region. The controlled current flows either through the doped control region or through a further doped region that forms a pn junction with the doped control region.

Other than coreless transformers or capacitive coupling interfaces, the junction transistor structure can be implemented without complex technologies and at low additional effort. Other than insulated gate field effect transistors IGFETs controlling a charge carrier channel ("MOS channel") by field effect, junction transistor structures can be more easily designed so that the operation of the junction transistor structure is not susceptible to backgate effects or is susceptible to similar effects only to a small extent.

According to an embodiment, a hole current through the junction transistor is controllable.

The junction transistor structure has a control input to receive a control signal for controlling the controlled current of the junction transistor structure. The control input is electrically connected to a doped control region. The control signal controls the hole current through the junction transistor structure or both the hole and the electron current. The p-type junction transistor structure can be a pnp BJT (bipolar junction transistor), a pnpn thyristor, or a pJFET (p channel junction field effect transistor), by way of example.

According to an embodiment, a controlled path of the junction transistor structure is electrically connected between the high side part and the low side part.

With the controlled path of the junction transistor structure electrically connected between the high side part and the low side part, the breakdown capability of the junction transistor structure supports the voltage separation between the high side part and the low side part. The breakdown capability may be at least 500V, e.g. at least 700V.

According to an embodiment, the junction transistor structure forms a p channel junction field effect transistor (pJFET).

The pJFET can be implemented without complex technologies and at low additional effort. In gate drivers based on SOI technology, the pJFET can be designed so that the operation of the pJFET is not susceptible to backgate effects or is susceptible to backgate effects only to a small extent.

The controlled path is between the source of the pJFET (pJFET source) and the drain of the pJFET (pJFET drain). With the controlled path of the pJFET electrically connected between the high side part and the low side part, the breakdown capability of the pJFET supports the voltage separation between the high side part and the low side part. The breakdown capability may be at least 500V, e.g., at least 700V. The pJFET source may receive the high side data signal and the pJFET drain may pass a corresponding low side data signal LDS to a logic circuit formed in the low side part. A gate of the pJFET (pJFET gate) may receive a constant bias signal with a sufficiently high voltage level to reliably turn on the pJFET. For example, the pJFET gate may be electrically connected to a supply potential of the high side part high side supply potential VB.

According to an embodiment, a source of the pJFET receives the high side data signal and a drain of the pJFET is signal-connected to a logic circuit in the low side part.

The logic circuit may be capable of generating and outputting a control signal in response to a level change of the low side data signal and possibly in response to other circuit conditions, the control signal affecting the operation of the first and/or second gate drive signals. In a comparative gate driver circuit that includes an insulated gate pFET, e.g., a pMOSFET (p channel MOSFET) with comparable breakdown capability as signal gate from the high side part to the low side part, operation of such pMOSFET may be prone to backgate effects, in particular when the pMOSFET is realized in SOI technology. The backgate effects may degrade the blocking capability of the pMOSFET and the performance of the gate driver circuit. On the other hand, the pJFET according to the embodiments can be designed such that the effect of any potential possibly building up across an insulator layer of an SOI structure is comparatively small.

According to an embodiment, the gate driver circuit can further include a p channel insulated gate field effect transistor that receives a data signal and that includes a controlled path electrically connected in series with the controlled path of the pJFET.

The p-channel insulated gate field effect transistor pFET can be formed in the high side part and outputs the high side data signal on the drain side in response to an original data signal received on the pFET gate. The pFET controlled path and the pJFET controlled path are electrically connected in series between the high side supply potential and an internal input structure of the low side part. The pFET passes the original data signal received at the pFET gate as the high side data signal to the pJFET source. While the pJFET is a normally-on device, the combination of pFET and pJFET emulates a normally-off device and simplifies data transfer from the high side part to the low side part.

According to an embodiment, the pJFET can be formed in a semiconductor layer, the semiconductor layer can be formed on an insulator layer, and the insulator layer can be formed on a substrate.

The substrate may include a conductive, e.g., a doped semiconductor material. The insulator layer may be a homogenous layer or a layer stack including two or more sublayers of different composition and/or internal structure (German: Gefüge) formed on a planar front surface of the substrate. The semiconductor layer may be formed on a planar front surface of the insulator layer. Compared to an pMOSFET with insulated gate and with comparable breakdown capability, the pJFET can be more easily designed so that the effects on the operation of the pJFET of any potential that may build up across the insulator layer remain small.

A thickness of the insulator layer can be in a range from 40nm to 1000nm.

According to an embodiment, the semiconductor layer can include a first layer portion comprising the low side part, a second layer portion comprising the high side part, and an intermediate layer portion between the first layer portion and the second layer portion, wherein the intermediate layer portion comprises a semiconducting portion of the pJFET.

Each of the first layer portion, the second layer portion and the intermediate layer portion may be a continuous layer portion or may include two or more laterally separated layer portions. For example, the first layer portion and the second layer portion may be stripe-shaped. Alternatively, the first layer portion may be formed in a closed frame or open frame around the second layer portion, wherein the intermediate layer portion may form a continuous or discontinuous circular, oval, or rectangular ring around the second layer portion and within the first layer portion. In particular, the second layer portion may be formed in a closed or open frame around the first layer portion, wherein the intermediate layer portion may form a continuous or discontinuous circular, oval, or rectangular ring around the first layer portion and within the second layer portion.

The gate driver circuit may further include bootstrap diode formed in the intermediate layer portion, wherein an anode of the bootstrap diode is electrically connected to a supply potential of the low side part and the cathode of the bootstrap diode is connected to a bootstrap capacitor in the high side part.

According to an embodiment, the pJFET can include a p doped source region formed at a side oriented to the high side part, a p doped drain region formed at a side oriented to the low side part, one, two or more n+ doped gate regions between the p doped source region and the p doped drain region, and a p doped channel region extending from the source region to a doped drain extension region. The p doped drain extension region is between the n+ doped gate regions and the p doped drain region (312).

Portions of the p doped source region, the p doped drain region, and the n+ doped gate regions may be formed by implanting ions into the semiconductor layer. The p doped source region may be homogenously doped and result from the same ion implantation (s) or may include two or more portions differing by at least one ion implantation parameter. The p doped drain region may be homogenously doped and result from the same ion implantation(s) or may include two or more portions differing by at least one ion implantation parameter. The n+ doped gate regions are closer to the p doped source region than to the p doped drain region.

According to an embodiment, the pJFET can include two or more n doped compensation regions, wherein each n doped compensation region extends from one of the n+ doped gate regions in direction of the p doped drain region, and wherein a mean net dopant concentration in the n doped compensation regions is at most half of the mean net dopant concentration in the n+ doped gate regions.

The p-doped compensation regions and the portions of the longitudinal sections of the channel region directly between the p-doped compensation regions may form a compensation structure, wherein along a line orthogonal to a direct connection line between the source region and the drain region, an integrated net dopant concentration in one of the longitudinal segments deviates by not more than a factor three from an integrated net dopant concentration in an adjacent one of the p-doped compensation regions. The compensation structure provides high voltage blocking capability and at the same time a low on-state resistance for the pJFET. In addition, the compensation structure reduces backgate effects.

According to an embodiment, the gate driver circuit may further include an n+ doped emitter region directly adjacent to the p doped drain region on a side opposite the n+ gate regions, wherein a difference between a net dopant concentration in the n+ doped emitter region and a net dopant concentration in the p doped drain region is sufficiently high to trigger injection of electrons from the n+ doped emitter region into the p doped drain region when the pJFET is turned on.

When the pJFET turns on and holes flow in the channel region from the p doped source region to the p doped drain region and across the junction between the p doped drain region and the n+ doped emitter region, the n+ doped emitter region injects electrons into the p doped drain region. The electrons contribute to a bipolar load current flow through the pJFET. As a result, the on-state resistance is lower than without the emitter region.

According to an embodiment, the gate driver circuit may further include a reverse diode. The reverse diode is electrically connected in series with the pJFET at a side of the low side part.

In particular, an anode of the reverse diode is electrically connected to the p doped drain regionor, in case the pJFET includes an n+ doped emitter region, to the n+ doped emitter region of the pJFET. A cathode of the reverse diode is electrically connected to a circuit element of the low side part, e.g., the logic circuit. The reverse diode blocks possible reverse currents and negative voltage spikes that may occur when the switches controlled by the gate driver circuit control an inductive load.

According to an embodiment, the gate driver circuit includes a reverse diode electrically connected in series with the pJFET, wherein the reverse diode is formed in the intermediate layer portion at a side oriented to the first layer portion.

In particular, an anode region of the reverse diode (RD anode region) and a cathode region of the reverse diode (RD cathode region) may be formed in the intermediate layer portion that includes the semiconducting portions of the pJFET.

According to an embodiment, the reverse diode can include an anode region and a cathode region, wherein the anode region is electrically connected to the p doped drain region and the anode region and the cathode region form a pn junction.

The RD anode region may be a homogenously doped region or may include at least two sub-regions of different mean net dopant concentration, wherein in at least one of the sub-regions the mean net dopant concentration is sufficiently high to form an ohmic contact with a conductive contact structure. The RD cathode region may be a homogenously doped region or may include at least two sub-regions of different mean net dopant concentration, wherein in at least one of the sub-regions 1, 2 the mean net dopant concentration is sufficiently high to form an ohmic contact with a conductive contact structure.

The RD anode region and the pJFET drain region may be directly adjacent to each other, wherein the RD anode region is opposite to the pJFET channel region and wherein the pJFET drain region and the RD anode region form a lateral unipolar junction in the intermediate layer portion.

The RD cathode region may be formed directly adjacent to the RD anode region on a side opposite the drain region, wherein the RD cathode region and the RD anode region form a lateral pn junction in the intermediate layer portion. In this way, the reverse diode can be easily integrated and can be placed in some distance to further elements and circuits of the low side part.

According to an embodiment, the reverse diode includes a p doped anode region and an n doped cathode region, wherein the p doped anode region is electrically connected to the n+ doped emitter region, and the p doped anode region and the n doped cathode region form a pn junction.

The RD anode region may be a homogenously doped region or may include at least two sub-regions of different mean net dopant concentration, wherein in at least one of the sub-regions the mean net dopant concentration is sufficiently high to form an ohmic contact with a conductive contact structure. The RD cathode region may be a homogenously doped region or may include at least two sub-regions of different mean net dopant concentration, wherein in at least one of the sub-regions the mean net dopant concentration is sufficiently high to form an ohmic contact with a conductive contact structure.

The RD anode region and the emitter region of the pJFET (pJFET emitter region) may be directly adjacent to each other, wherein the RD anode region is opposite to the pJFET drain region and wherein the pJFET emitter region and the RD anode region form a lateral pn junction in the intermediate layer portion. A highly conductive structure may electrically connect the RD anode region and the pJFET emitter region.

The RD cathode region may be formed directly adjacent to the RD anode region on a side opposite the pJFET emitter region, wherein the RD cathode region and the RD anode region form a further lateral pn junction in the intermediate layer portion. In this way, the reverse diode can be easily integrated and can be placed in some distance to further elements and circuits of the low side part.

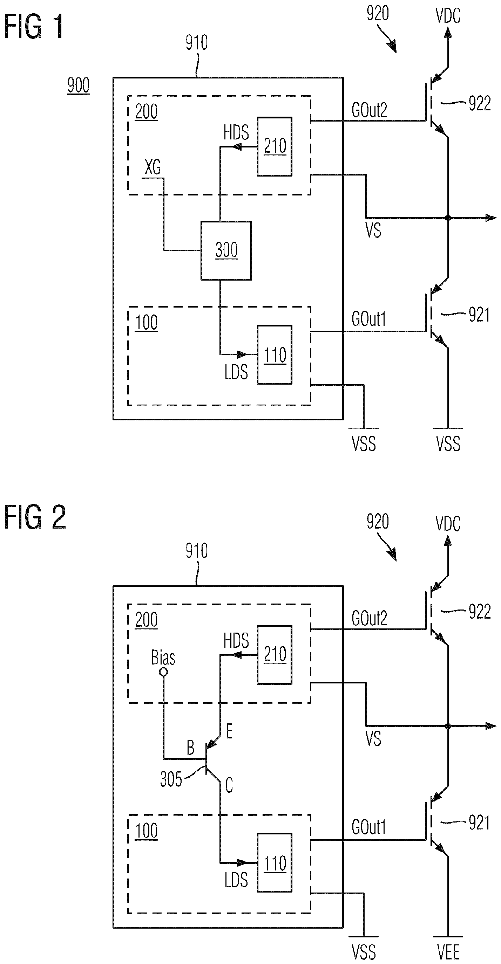

FIG. 1 shows an electric switch assembly 900 including two power semiconductor devices in a half bridge configuration, and a gate driver circuit 910 controlling the half bridge 920. The half bridge 920 may be operated separately from other electric switches, or may be part of a full bridge, e.g., a H-bridge that switches the polarity of a voltage applied to a load. The half bridge 920 can be integrated in a power module. The gate driver circuit 910 may be integrated in the same power module or may be arranged outside the power module that houses the half bridge 920.

The half bridge 920 includes a low side switch 921 and a high side switch 922. Each of the low side switch 921 and the high side switch 922 is or includes a power semiconductor switch, e.g., a silicon power MOSFET, a silicon IGBT (insulated gate bipolar transistor), a gallium nitride HEMT (high electron mobility transistor), or a silicon carbide MOSFET.

Controllable load paths of the high side switch 922 and the low side switch 921 are electrically connected in series between a supply potential VDC and a first reference potential VSS. The electric switch assembly 900 controls a current through a load connected to an output node of the half bridge 920 between the high side switch 922 and the low side switch 921.

The gate driver circuit 910 includes a high side part 200 and a low side part 100. The low side part 100 generates a first gate drive signal Gout1 and outputs the first gate drive signal Gout1 between a first gate output and the first reference potential VSS. The low side switch 921 receives the first gate drive signal Gout1 at a gate input. The high side part 200 generates a second gate drive signal Gout2 and outputs the second gate drive signal Gout2 between a second gate output and a second reference potential VS. The second reference potential VS may be connected to the output node of the half bridge 920. The high side switch 922 receives the second gate drive signal Gout2 at a gate input.

A logic circuit 210 of the high side part 200 generates a high side data signal HDS. A junction transistor structure 300 passes the high side data signal HDS to the low side part 100. A logic circuit 110 in the low side part 100 receives a low side data signal LDS derived from the high side data signal HDS.

The high side data signal HDS may be a signal that indicates a fault condition. For example, a half bridge 920 includes IGBTs as low side switch 921 and high side switch 922 and the high side data signal HDS may indicate a desaturation of the high side switch 922 in case a short-circuit condition occurs.

An auxiliary signal XG controls a current flow through the controlled path of the junction transistor structure 300. The auxiliary signal XG may be a constant voltage.

The auxiliary signal XG controls at least a hole current flow in the controlled path. In addition to the hole current flow, the auxiliary signal XG may also control the electron current flow in the controlled path. Accordingly, the junction transistor structure 310 can be a pnp BJT, a pnpn thyristor, or a pJFET.

In FIG. 2 the junction transistor structure is a pnp BJT 305 with the emitter E signal-connected to the logic circuit 210 in the high side part 200, the collector C signal-connected to the logic circuit 110 in the low side part 100, and the base B connected to a constant bias voltage Bias. The constant bias voltage Bias and a current source sourcing the base current for the pnp BJT 305 are designed to reliably turn on the pnp BJT 305. The pnp BJT 305 receives the high side data signal HDS at the emitter E. The logic circuit 110 in the low side part 100 receives the low side data signal LDS from the collector C of the pnp BJT 305.

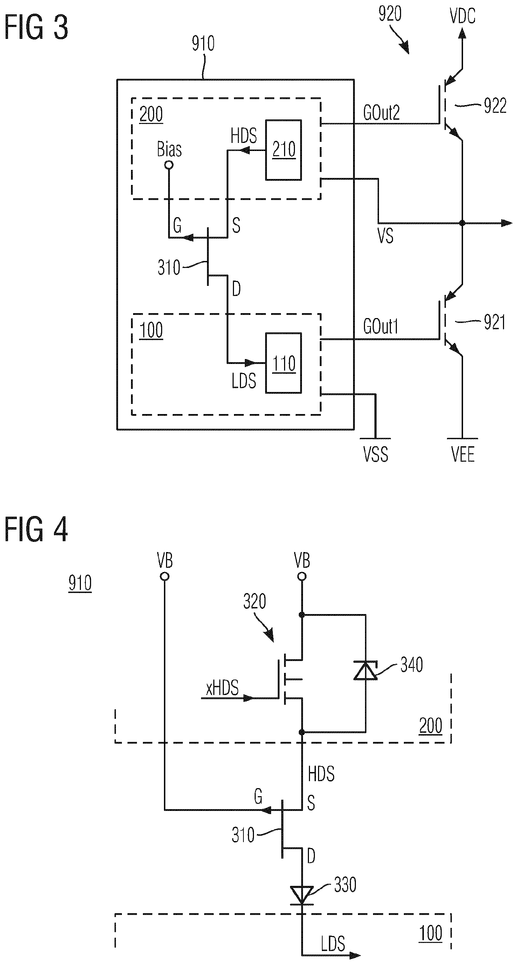

In FIG. 3 the junction transistor structure 300 is a pJFET 310 with the source S signal-connected to the logic circuit 210 in the high side part 200, the drain D signal-connected to the logic circuit 110 in the low side part 100, and the gate G connected to a constant bias voltage Bias. The constant bas voltage Bias is selected to reliably turn on the pJFET 310. The pJFET 310 receives the high side data signal HDS at the source S. The logic circuit 110 in the low side part 100 receives the low side data signal LDS from the drain D of the pJFET 310.

In response to a level change of the low side data signal LDS and, if applicable, in dependence of other circuit conditions, the logic circuit 110 in the low side part 100 can output a control signal that influences the operation of the first and/or second gate drive signals and/or is output to another integrated circuit.

In FIG. 4, the high side part 200 includes a pMOSFET 320. The controlled paths of the pMOSFET 320 and the pJFET 310 are electrically connected in series between a high side supply potential VB and an internal input structure of the low side part 100. The pMOSFET 320 receives an original data signal xHDS at the gate and outputs the high side data signal HDS on the drain side to the source of the pJFET 310. The combination of pMOSFET 320 and pJFET 310 emulates a normally-off device and simplifies data transfer from the high side part 200 to the low side part 100.

A clamping diode 340 is electrically connected in parallel to the controlled path of the pMOSFET 320. A reverse diode 330 is electrically connected in series with the pJFET 310 between the controlled path of the pJFET 310 and the low side part 100.

An anode of the reverse diode 330 is electrically connected to the drain or, if the pJFET includes an emitter region, to the emitter region of the pJFET 310. A cathode of the reverse diode 330 is electrically connected to a circuit element of the low side part 100. For example, the cathode of the reverse diode 330 can be electrically connected to the logic circuit 110 of the low side part 100. The reverse diode 330 blocks possible reverse currents and negative voltage spikes that may occur when the power semiconductor switches controlled by the gate driver circuit 910 control an inductive load.

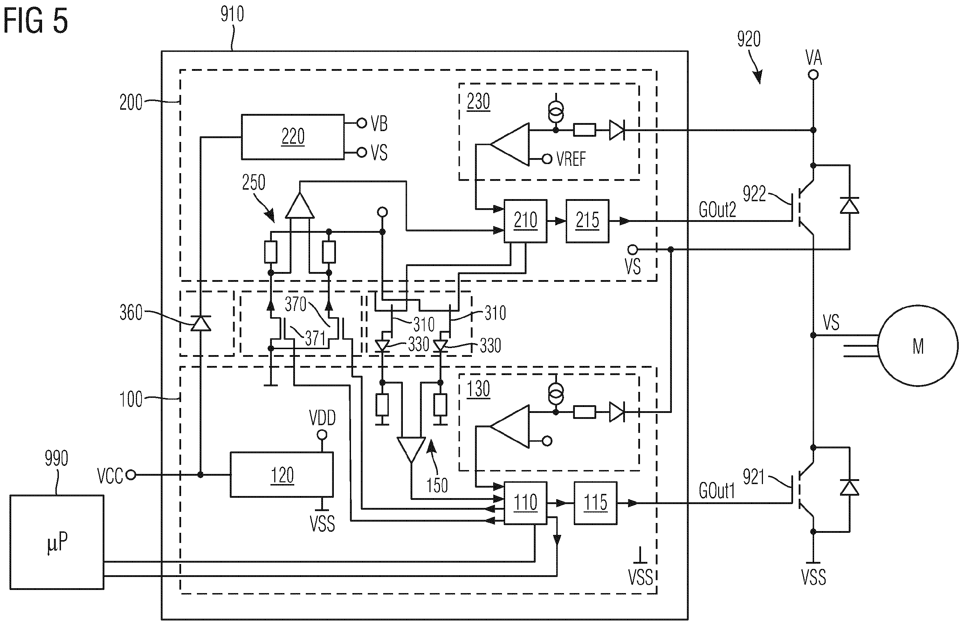

In FIG. 5, the high side part 200 of a gate driver circuit 910 includes a high side power supply circuit 220 to obtain a positive power supply voltage VB for the high side part 200 (high side supply potential VB), wherein a bootstrap diode 360 charges a bootstrap capacitor from an external supply voltage VCC. The positive power supply voltage VB for the high side part 200 is referenced to a high side reference potential VS, which corresponds to the potential of the output node of the half bridge 920.

A high side desaturation detection circuit 230 is connected to the supply potential VDC of the half bridge 920, detects a desaturation of the high side switch 922, and outputs a high side desaturation signal indicating whether a desaturation condition exists. A high side receiver circuit 250 receives a differential gate control signal from two nMOSFETs 370 and outputs a single-ended high side gate control signal. A logic circuit 210 in the high side part 200 receives the high side desaturation signal and the high side gate control signal. The logic circuit 210 in the high side part 200 outputs a second gate drive signal Gout2 in response to the high side gate control signal provided that the high side desaturation signal does not indicate a desaturation condition. A high side driver 215 may drive the second gate drive signal GOut2.

The logic circuit 210 further outputs a differential high side data signal. Two pJFETs 310 transmit the differential high side data signal from the high side part 200 to the low side part 100. Reverse diodes 330 are electrically connected between each pJFET 310 and a low side receiver circuit 150.

The low side part 100 of a gate driver circuit 910 includes a low side power supply circuit 120 to obtain a positive power supply voltage VDD for the low side part 100. The positive power supply voltage VDD for the low side part 100 is referenced to the first reference potential VSS.

A low side desaturation detection circuit 130 is connected to the output node of the half bridge 920, detects a desaturation of the low side switch 921, and outputs a low side desaturation signal indicating whether a desaturation condition exists. A low side receiver circuit 150 receives a differential low side data signal from the two pJFETs 310 and outputs a single-ended low side data signal. A logic circuit 110 in the low side part 100 receives the low side data signal, the low side desaturation signal, and a low side gate control signal from an external source like a processor 990. The logic circuit 110 in the low side part 100 outputs a first gate drive signal Gout1 in response to the low side gate control signal provided that none of the low side desaturation signal and the low side data signal indicates a desaturation condition. A low side driver stage 115 drives the first gate drive signal Gout1.

The logic circuit 110 further outputs a differential gate control signal. The two nMOSFETs 370 transmit the differential gate control signal from the low side part 100 to the high side part 100.

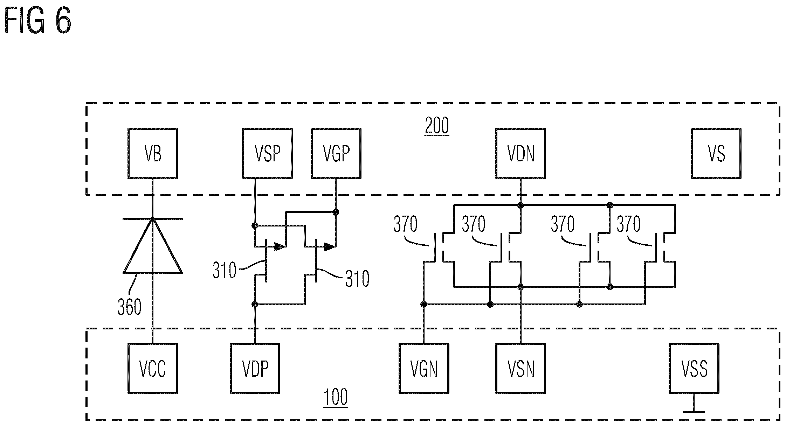

FIG. 6 shows a configuration of a gate driver circuit 910 for the transfer of single-ended data signals between the low side part 100 and the high side part 200.

Two pJFETs 310 are electrically connected in parallel between a VSP node in the high side part 200 and a VDP node in the low side part 100. The gates of both pJFETs 310 are connected to a common VGP node in the high side part 200.

Four nMOSFETs 370 are electrically connected in parallel between a VDN node in the high side part 200 and a VSN node in the low side part 100. The gates of the nMOSFETs 370 are connected to a common VGN node in the low side part 100.

An anode of a bootstrap diode 360 is electrically connected to a VCC node in the low side part 100. A cathode of the bootstrap diode 360 is electrically connected to a VB node in the high side part 200.

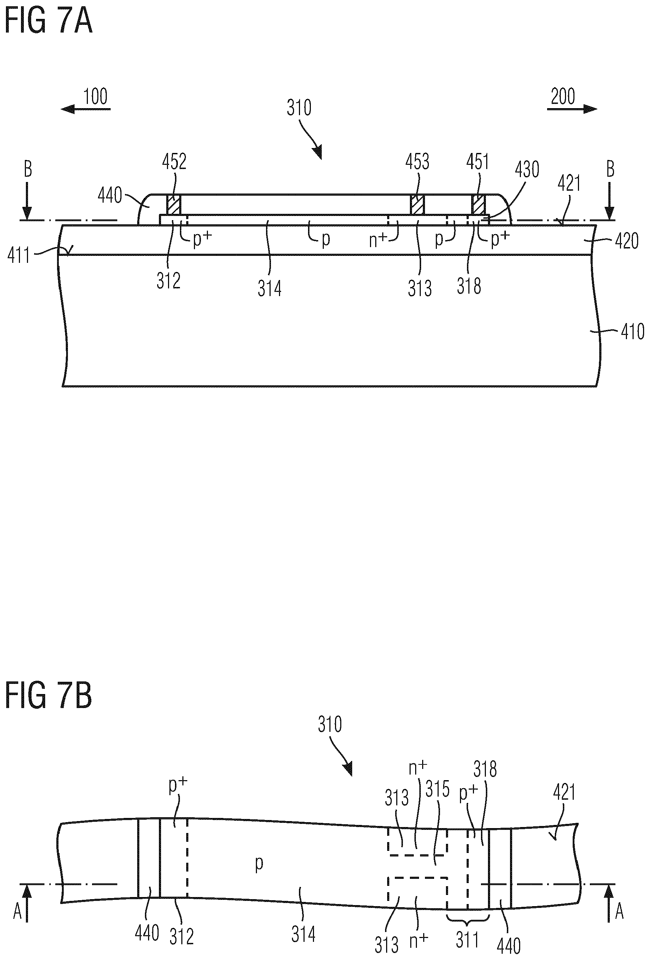

FIG. 7A and FIG. 7B show a pJFET 310 for data transfer from the high side part to the low side part of a gate driver circuit implemented in SOI technology.

The pJFET 310 is formed in a semiconductor layer 430. The semiconductor layer 430 is formed on an insulator layer 420. The insulator layer 420 is formed on a substrate 410.

The substrate 410 may include a conductive, e.g., a doped semiconductor material. The semiconductor material may be single crystalline silicon. The substrate 410 has a planar first substrate surface 411 at a front side. The first substrate surface 411 extends in horizontal directions. A vertical direction is orthogonal to the first substrate surface 411.

The insulator layer 420 is formed on the first substrate surface 411 and has a uniform thickness. The insulator layer 420 may be a homogenous layer or a layer stack including two or more sublayers of different composition and/or internal structure (German: Gefüge). The insulator layer 420 may include thermally grown and/or deposited silicon oxide. A thickness of the insulator layer 420 is in a range from 40nm to 1000nm.

The semiconductor layer 430 is formed on a planar front surface 421 of the insulator layer 420. The semiconductor layer 430 can be a layer from single crystalline silicon.

The pJFET 310 is formed in a section of the semiconductor layer 430 that is laterally separated from further sections of the semiconductor layer 430. An interlayer dielectric 440 is formed on the semiconductor layer 430. The interlayer dielectric 440 may cover sidewalls of the section of the semiconductor layer 430 in which the pJFET 310 is formed. Alternatively, STIs (shallow trench isolations) or insulator trench structures laterally separate neighboring sections of the semiconductor layer 430 and the interlayer dielectric 440 covers the STIs and/or insulator trench structures.

The pJFET includes a p doped source region 311 formed at a side oriented to the high side part 200, a p+ (heavily p doped) drain region 312 formed at a side oriented to the low side part 100, one, two or more n+ (heavily n doped) gate regions 313 between the source region 311 and the p+ drain region 312, a p (less heavily doped) drain extension region 314 extending from the p+ drain region 312 to the n+ gate region (s) 313 and one or more p channel region (s) 315 extending between neighboring n+ gate regions 313 from the p doped source region 311 to the p drain extension region 314. The n+ gate regions 313 are closer to the p doped source region 311 than to the p+ drain region 312. The p doped source region 311 includes a p+ source contact portion 318 and a lower doped buffer portion.

The buffer portion of the p doped source region 311, the p channel regions 315 and the p drain extension region 314 may have the same dopant concentration. The source region 311, the drain region 312, and the gate regions 313 may be formed by implanting ions into the semiconductor layer 430.

A source contact structure 451 extends through the interlayer dielectric 440. The source contact structure 451 and the p+ source contact portion 318 form an ohmic contact. A drain contact structure 452 extends through the interlayer dielectric 440. The drain contact structure 452 and the p+ drain region 312 form an ohmic contact. Gate contact structures 453 extend through the interlayer dielectric 440. The gate contact structures 453 and the n+ gate regions 313 form ohmic contacts.

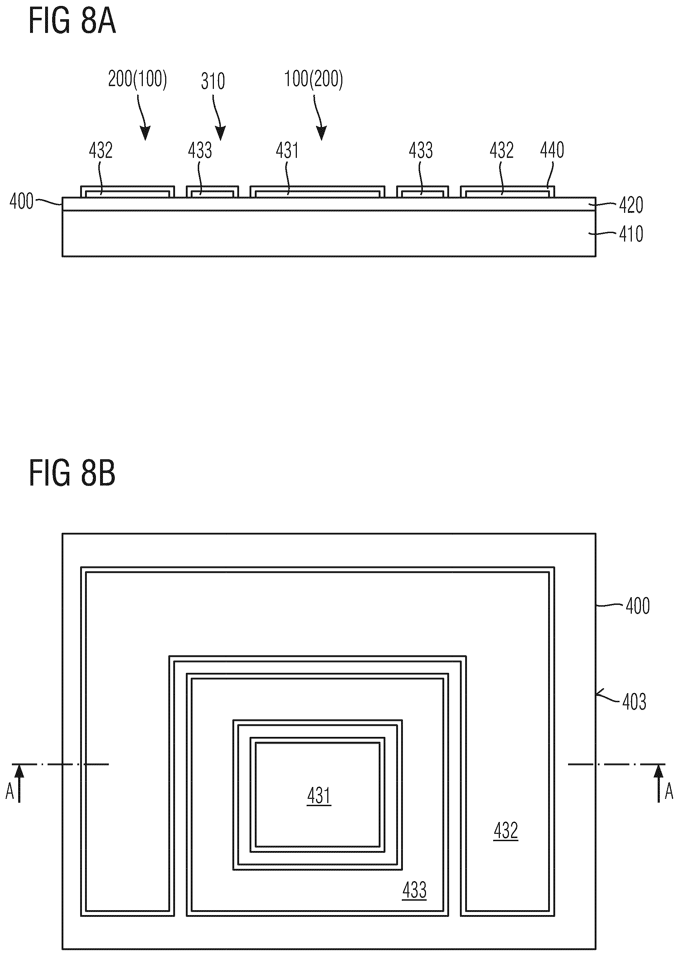

FIG. 8A and FIG. 8B show a configuration example for a semiconductor die 400 including a semiconductor layer 430 with laterally separated portions.

The semiconductor layer 430 includes a first layer portion 431, a second layer portion 432, and an intermediate layer portion 433. Electronic circuits of the low side part 100 are formed in the first layer portion 431 or in the second layer portion 432. Electronic circuits of the high side part 200 are formed in the second layer portion 432 or in the first layer portion 431, wherein the electronic circuits of the low side part 100 and the electronic circuits of the high side part are formed in different layer portions 431, 432. The intermediate layer portion 433 is formed between the first layer portion 431 and the second layer portion 432. The semiconducting portion of the pJFET 310 is formed in the intermediate layer portion 433.

Each of the first layer portion 431, the second layer portion 432 and the intermediate layer portion 433 may be a continuous layer portion as illustrated. Alternatively, one, two, or each of the first layer portion 431, the second layer portion 432 and the intermediate layer portion 433 includes two or more laterally separated layer sections. In the illustrated embodiment, the intermediate layer portion 433 forms a closed rectangular frame around a rectangular first layer portion 431. The second layer portion 432 is formed between the intermediate layer portion 433 and a lateral surface 403 of the semiconductor die 400 and forms a continuous open frame around the intermediate layer portion 433.

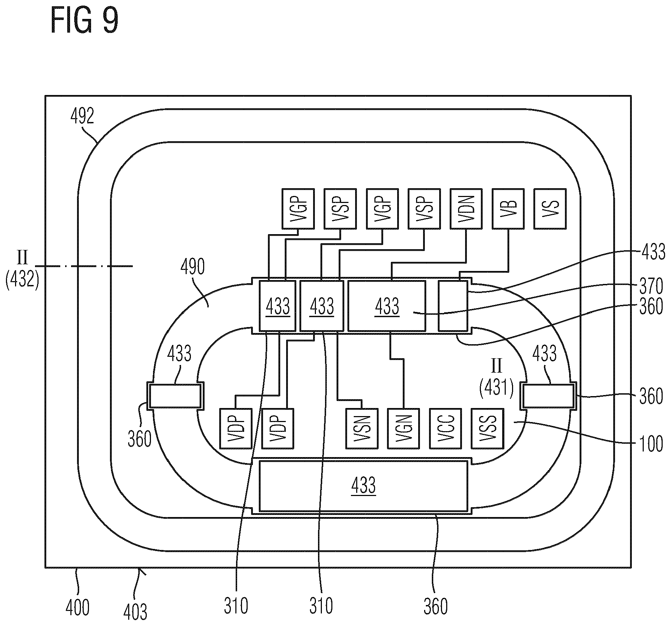

FIG. 9 shows a configuration example for portions of a semiconductor layer 430 that includes the circuit elements of FIG. 6.

The first layer portion 431 is formed in a region I within an inner termination structure 490 that laterally surrounds region I completely. The second layer portion 432 is formed in a region II outside the inner termination structure 490. The termination structure 490 ensures a nominal voltage breakdown capability between region I and region II. An outer termination structure 491 between region II and the lateral surface 403 may laterally surround region II completely. The low side part 100 is formed in region I. The high side part 200 is formed in region II.

The first layer portion 431 may include one continuous layer section or two or more laterally separated layer sections in region I. The second layer portion 432 may include one continuous layer section or two or more laterally separated layer sections in region II.

The intermediate layer portion 433 may include several laterally separated sections formed above the inner termination structure 490 and extending on both sides beyond the inner termination structure 490. The laterally separated sections of the intermediate layer portion 433 can be formed exclusively above straight sections of the inner termination structure 490. Two pJFETs 310, an nMOSFET 370 and four portions of a bootstrap diode 360 are formed in laterally separated sections of the intermediate layer portion 433.

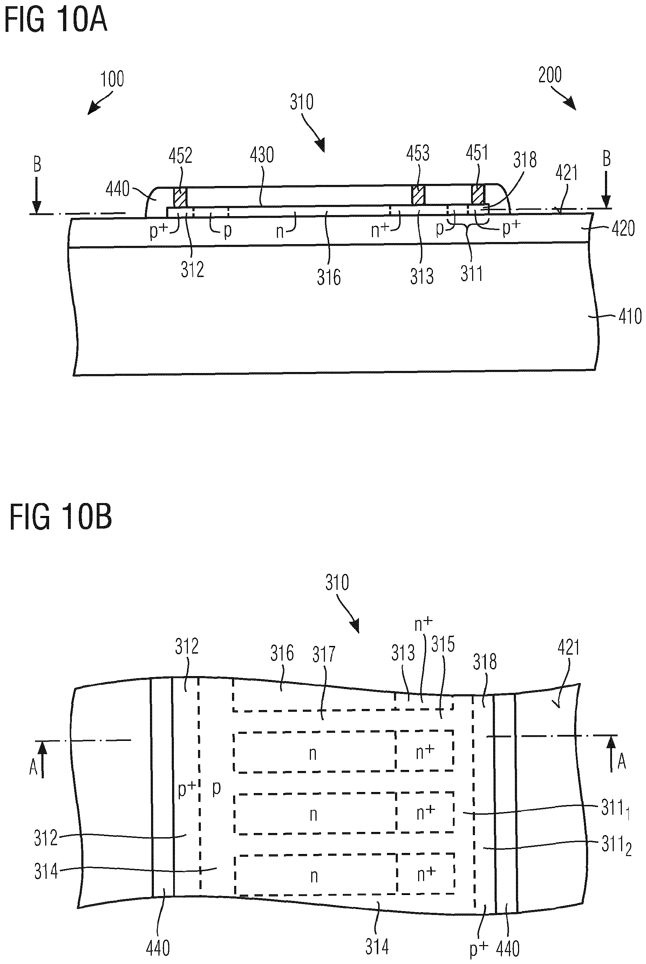

FIG. 10A and FIG. 10B show a pJFET 310 that includes n doped compensation regions 316. Each n doped compensation region 316 extends from one of the n+ gate regions 313 in direction of the p+ drain region 312. Between neighboring n doped compensation regions 316, the p doped drain extension region 314 forms p doped stripe sections 317. A width of the p doped stripe sections 317 may be equal to the width of the channel regions 315. A mean net dopant concentration in the n doped compensation regions 316 is at most half of the mean net dopant concentration in the n+ gate regions 313.

The n doped compensation regions 316 and the p doped stripe sections 317 of the drain extension region 314 form a compensation structure, wherein along a line orthogonal to a direct connection line between the p doped source region 311 and the p+ drain region 312, an integrated net dopant concentration in one of the p doped stripe sections 317 deviates by not more than a factor three from an integrated net dopant concentration in an adjacent one of the n doped compensation regions 316. The compensation structure provides high voltage blocking capability and at the same time a low on-state resistance for the pJFET 310. In addition, the compensation structure reduces backgate effects.

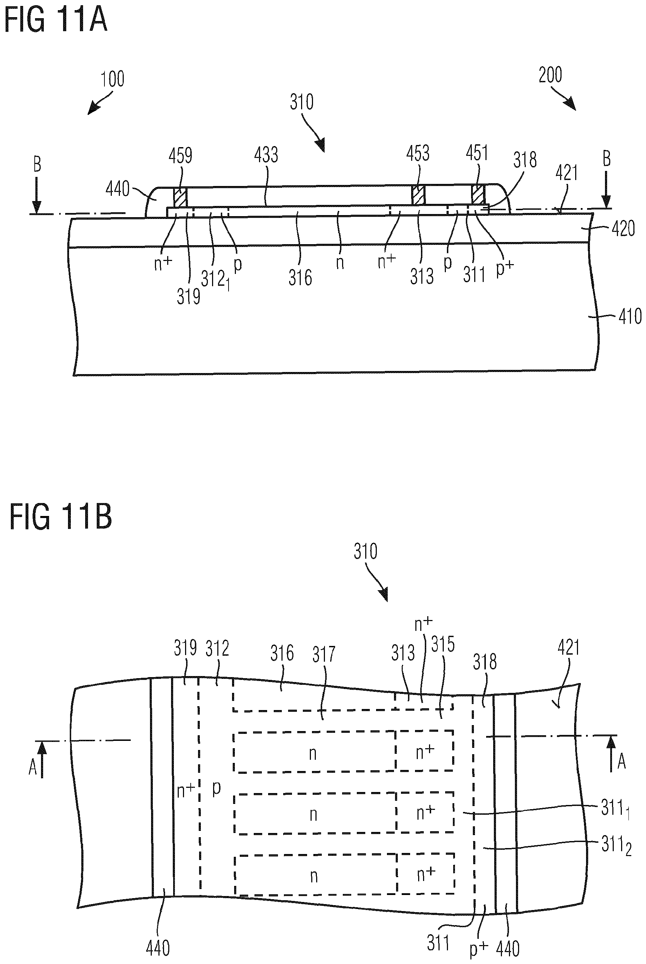

FIG. 11A and FIG. 11B show a pJFET 310 that includes an n+ doped emitter region 319 directly adjacent to a p doped drain region 312 on a side opposite the n+ gate regions 313. The n+ doped emitter region 319 and the p doped drain region 312 form a pn junction. A difference between a net dopant concentration in the n+ emitter region 319 and a net dopant concentration in the p doped drain region 312 is sufficiently high to trigger injection of electrons from the n+ emitter region 319 into the p doped drain region 312 when the pJFET 310 is turned on. The p doped drain region 312 has a lower dopant concentration than in the previous embodiments and is formed between the n+ emitter region 319 and the p doped stripe sections 317 of the drain extension region 314. An emitter contact structure 459 extends through the interlayer dielectric 440. The emitter contact structure 459 and the n+ emitter region 319 form an ohmic contact.

When the pJFET 310 turns on and holes flow in the channel region 315 from the source region 311 to the drain region 312 and across the pn junction between the p doped drain region 312 and the n+ emitter region 319, the n+ emitter region 319 injects electrons into the p doped drain region 312. The electrons contribute to a bipolar load current flow through the pJFET 310. As a result, the on-state resistance is lower than without the n+ emitter region 319.

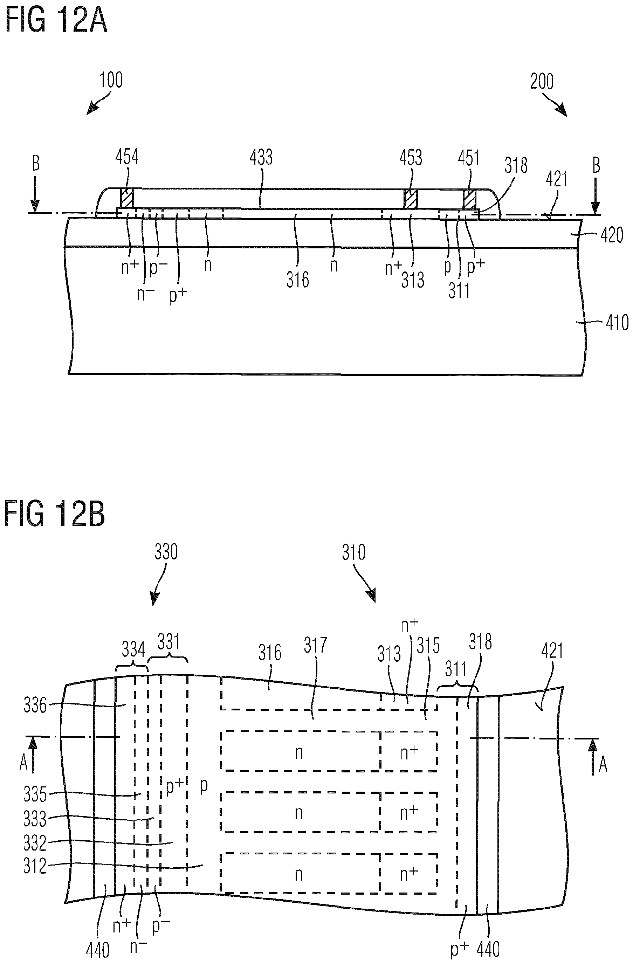

FIG. 12A and FIG. 12B show a reverse diode 330 and a pJFET 310 formed in the same section of the intermediate layer portion 433.

An anode region 331 and a cathode region 334 of the reverse diode 330 are formed at a side of the pJFET 310 oriented to the low side part 100. The anode region 331 and the drain region 312 of the pJFET 310 may at least partly merge.

In the illustrated embodiment, the anode region 331 includes a p+ anode portion 332 and a p- anode portion 333. The p+ anode portion 332 and the p doped drain region 312 form a unipolar junction. The p- anode portion 333 and the p+ anode portion 332 form a unipolar junction. The cathode region 334 includes an n- cathode portion 335 and an n+ cathode portion 336. The n- cathode portion 335 and the p- anode portion 333 form a pn junction. The n+ cathode portion 336 and the n- cathode portion 335 form a unipolar junction. A cathode contact structure 454 extends through the interlayer dielectric 440. The cathode contact structure 454 and the n+ cathode portion 336 form an ohmic contact.

The reverse diode 330 is electrically connected in series with the pJFET 310 at a side of the low side part 100. The reverse diode 330 blocks possible reverse currents and negative voltage spikes that may occur when the switches controlled by the gate driver circuit control an inductive load.

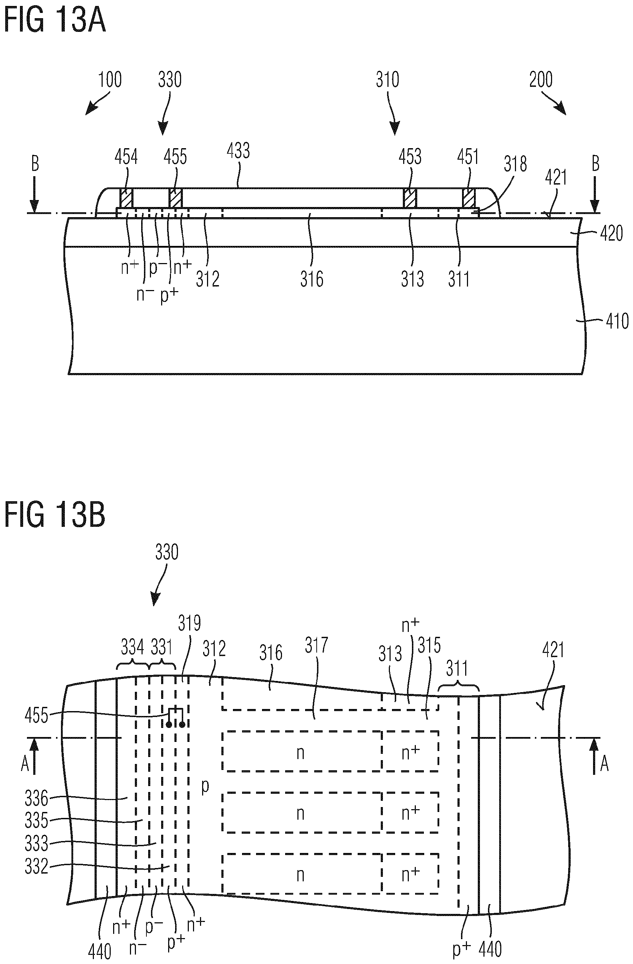

FIG. 13A and FIG. 13B show a combination of a reverse diode 330 with a pJFET 310 that is combined with an n+ emitter region 319 formed between the drain region 312 of the pJFET 310 and the anode region 331 of the reverse diode 330.

The n+ emitter region 319 and the anode region 331 of the reverse diode 330 form a pn junction. An emitter-anode connection structure 455 extends through the interlayer dielectric 440. The emitter-anode connection structure 455 and the n+ emitter region 319 form an ohmic contact, and the emitter-anode connection structure 455 and the p doped anode region 331 form an ohmic contact. The emitter-anode connection structure 455 short-circuits the pn junction between the n+ emitter region 319 and the anode region 331 of the reverse diode 330

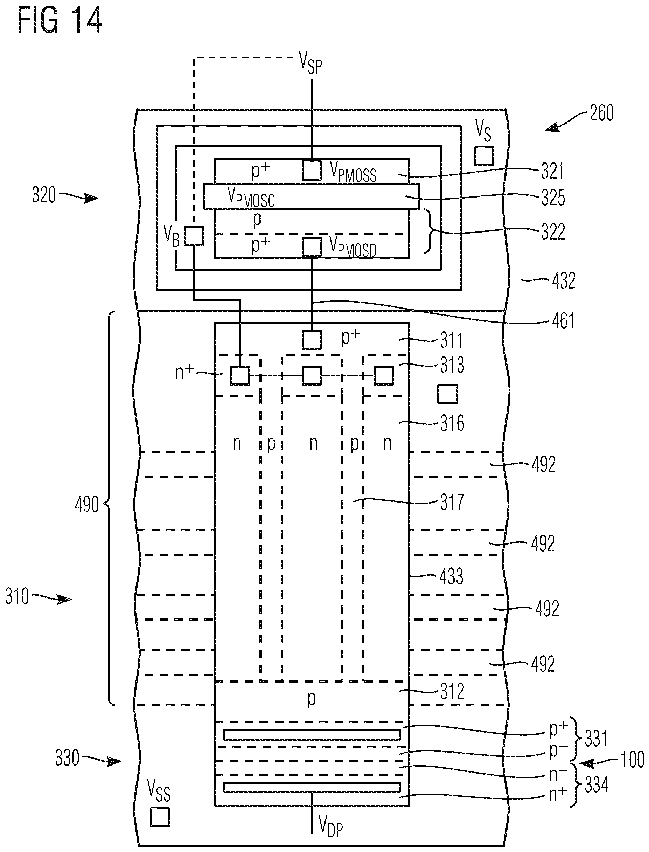

FIG. 14 shows a plan view of a pJFET 310 formed in an intermediate layer portion 433 over an inner termination structure 490. The inner termination structure 490 includes shield rings 492.

The pJFET 310 includes a p+ doped source region 311 and p doped drain region 312. P doped stripe sections 317 of a drain extension region connect the p+ doped source region 311 and the p doped drain region 312 and separate neighboring n+ gate regions 313 and neighboring n doped compensation regions 316. A reverse diode 330 comprising an anode region 331 and a cathode region 332 is formed in the same intermediate layer portion 433.

A pMOSFET 320 formed in the high side part 200 includes a p+ doped MOS source region 321, a p doped MOS drain region 322 and an n doped body region below a polysilicon MOS gate electrode 325. A conductor line 461 connects the MOS drain region 322 with the p+ doped source region 311 of the pJFET 310.

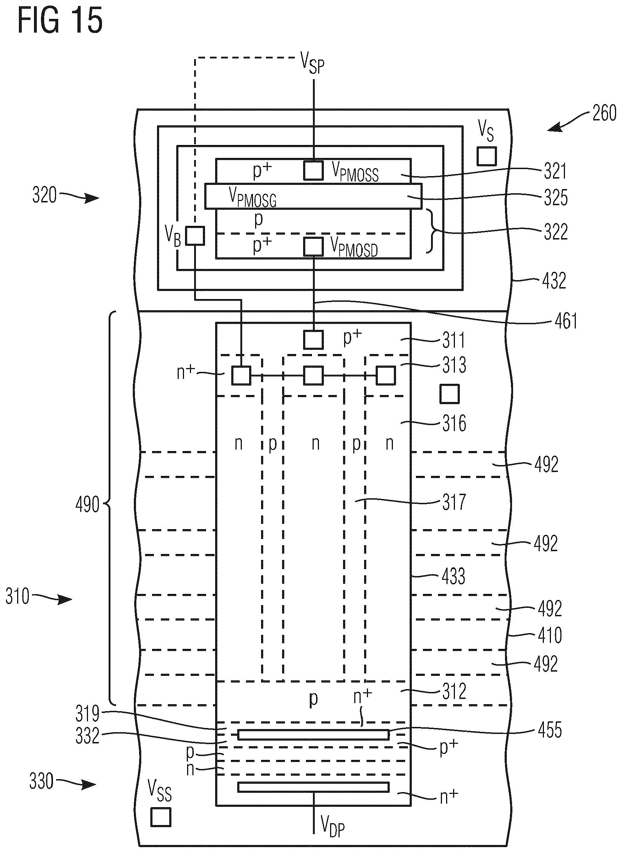

FIG. 15 shows a plan view of a pJFET 310 formed in an intermediate layer portion 433 that further includes an n+ doped emitter region 319 formed between the pJFET 310 and the reverse diode 320. An emitter-anode connection structure 455 electrically connects the n+ doped emitter region 319 and a p+ anode portion 332 of the reverse diode 320.

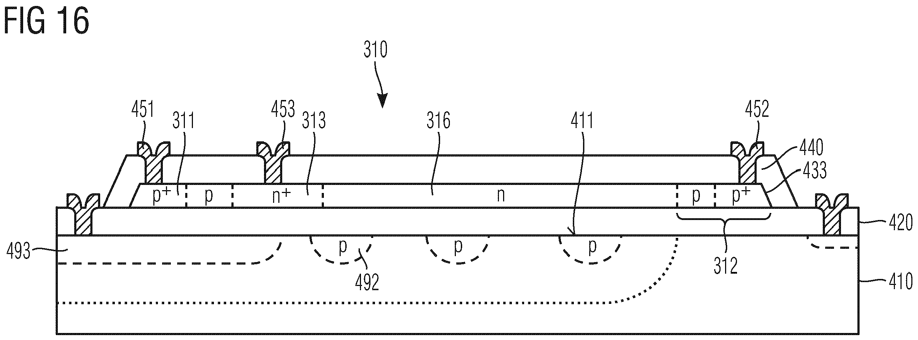

FIG. 16 shows a pJFET 310 formed on an inner termination structure 490 that includes p doped shield rings extending from the first substrate surface 411 into a substrate 410 with n type background doping. A p doped shield well 493 extends in the high side part 200 from the first substrate surface 411 into the substrate 410.

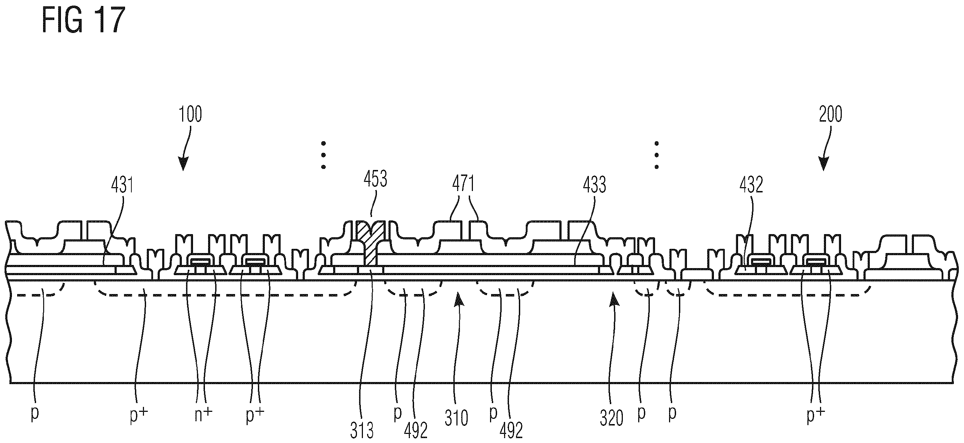

In FIG. 17, the semiconductor layer includes first layer portions 431 in the low side part 100 and second layer portions 432 in the high side part 200. Metal field rings 471 are formed in a vertical direction of the intermediate layer portion 433, wherein dielectric layers vertically separate the field rings 471 and the intermediate layer portion 433.

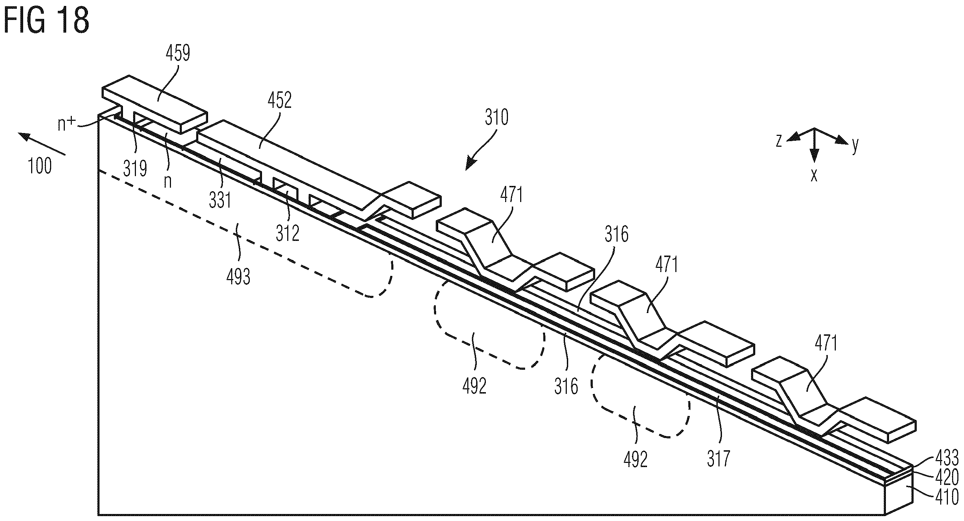

FIG. 18 shows a pJFET 310 with an n+ emitter region 319 formed at the side oriented to the low side part 100. Metal field rings 471 are formed in the vertical direction of p doped shield rings 492 in the substrate 410

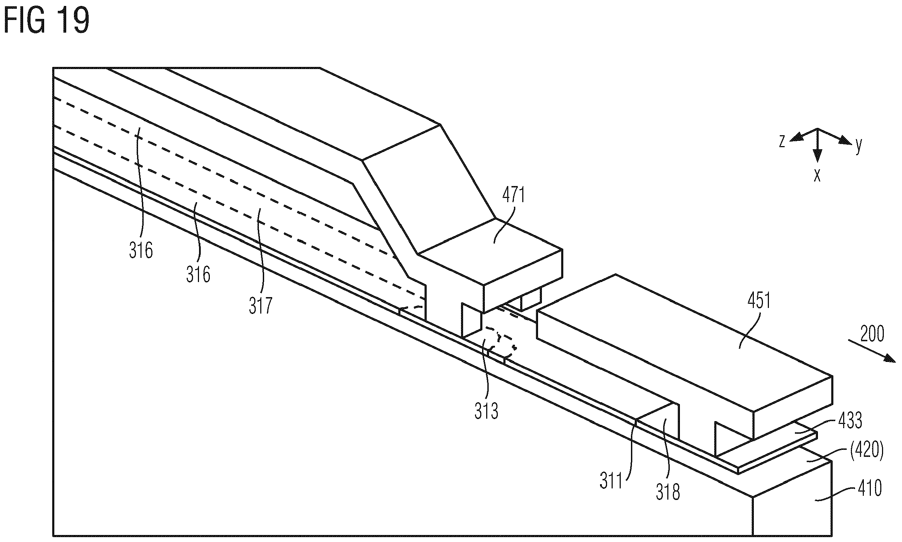

FIG. 19 shows an end portion of a pJFET 310 oriented to the high side part 200. A gate contact structure 453 is in direct contact with the n+ doped gate regions 313. A source contact structure 451 is in direct contact with the p+ source contact portion 318 of the source region 311.

## Claims

1. A gate driver circuit, comprising:
a low side part (100) configured to output a first gate drive signal between a first gate output and a first reference potential (VSS);
a high side part (200) configured to generate a high side data signal and to output a second gate drive signal between a second gate output and a second reference potential (VS); and
a p-type junction transistor structure (300) configured to pass the high side data signal to the low side part (100) .

2. The gate driver circuit according to the preceding claim,
wherein a hole current through the junction transistor structure (300) is controllable.

3. The gate driver circuit according to any of the preceding claims,
wherein a controlled path of the junction transistor structure (300) is electrically connected between the high side part (200) and the low side part (100).

4. The gate driver circuit according to any of the preceding claims,
wherein the junction transistor structure (300) forms a p channel junction field effect transistor (310).

5. The gate driver circuit according to claim 4,
wherein a source of the p-channel junction field effect transistor (310) is configured to receive the high side data signal, and wherein a drain of the p-channel junction field effect transistor (310) is signal-connected to a logic circuit (110) in the low side part (100) .

6. The gate driver circuit according to any of claims 4 and 5, further comprising:
a p-channel insulated gate field effect transistor (320) configured to receive a data signal and comprising a controlled path electrically connected in series with the controlled path of the p-channel junction field effect transistor (310).

7. The gate driver circuit according to any of claims 4 to 6,
wherein the p-channel junction field effect transistor (310) is formed in a semiconductor layer (430), the semiconductor layer (430) is formed on an insulator layer (420), and the insulator layer (420) is formed on a substrate (410) .

8. The gate driver circuit according to the preceding claim,
wherein the semiconductor layer (430) comprises a first layer portion (431) comprising the low side part (100), a second layer portion (432) comprising the high side part (200), and an intermediate layer portion (433) between the first layer portion (431) and the second layer portion (432), wherein the intermediate layer portion (433) comprises a semiconducting portion of the p-channel junction field effect transistor (310).

9. The gate driver circuit according to any of claims 4 to 8,
wherein the p-channel junction field effect transistor (310) comprises a p doped source region (311) formed at a side oriented to the high side part (200), a p doped drain region (312) formed at a side oriented to the low side part (100), one or more n+ doped gate regions (313) between the p doped source region (311) and the p doped drain region (312), and one or more p doped channel region (315) extending from the source region (311) to a p doped drain extension region (314) between the n+ doped gate regions (313) and the p doped drain region (312).

10. The gate driver circuit according to the preceding claim,
wherein the p-channel junction field effect transistor (310) comprises one or more n doped compensation regions (316), wherein each n doped compensation region (316) extends from one of the gate regions (313) in direction of the drain region (312), and wherein a mean net dopant concentration in the n doped compensation regions (316) is at most half of the mean net dopant concentration in the n+ doped gate regions (313).

11. The gate driver circuit according to any of claims 9 and 10, further comprising:
an n+ emitter region (319) directly adjacent to the p doped drain region (312) on a side opposite the n+ gate regions (313), wherein a difference between a net dopant concentration in the n+ emitter region (319) and a net dopant concentration in the drain region (312) is sufficiently high to trigger injection of electrons from the n+ emitter region (319) into the p doped drain region (312) when the p-channel junction field effect transistor (310) is turned on.

12. The gate driver circuit according to any of claims 4 to 11, further comprising:
a reverse diode (330) electrically connected in series with the p-channel junction field effect transistor (310) at a side of the low side part (100).

13. The gate driver circuit according to claim 8, further comprising:
a reverse diode (330) electrically connected in series with the p-channel junction field effect transistor (310), wherein the reverse diode (330) is formed in the intermediate layer portion (433) at a side oriented to the first layer portion (431).

14. The gate driver circuit according to the preceding claim,
wherein the reverse diode (330) comprises a p doped anode region (331) and an n doped cathode region (332), wherein the p doped anode region (331) is electrically connected to the p doped drain region (312), and wherein the p doped anode region (331) and the n doped cathode region (332) form a pn junction.

15. The gate driver circuit according to claim 11 and any of claims 12 and 13,
wherein the reverse diode (330) comprises a p doped anode region (331) and an n doped cathode region (332), wherein the p doped anode region (331) is electrically connected to the n+ emitter region (319) and the p doped anode region (331) and the n doped cathode region (332) form a pn junction.

## Amended claims

### Amended claims in accordance with Rule 137(2) EPC.

1. A gate driver circuit, comprising:
a low side part (100) configured to output a first gate drive signal between a first gate output and a first reference potential (VSS);
a high side part (200) configured to generate a high side data signal and to output a second gate drive signal between a second gate output and a second reference potential (VS); and
a p-type junction transistor structure (300) comprising a source, a drain, and a gate, or an emitter, a collector, and a base, the p-type junction transistor structure (300) being configured to pass the high side data signal to the low side part (100), wherein (a) the source is configured to receive the high side data signal, the drain is signal-connected to a logic circuit (110) in the low side part (100), and the gate is configured to receive a constant bias signal to turn on the p-type junction transistor structure (300), or (b) the emitter is configured to receive the high side data signal, the collector is signal-connected to a logic circuit (110) in the low side part (100), and the base is configured to receive a constant bias signal to turn on the p-type junction transistor structure (300).

2. The gate driver circuit according to the preceding claim,
wherein a hole current through the junction transistor structure (300) is controllable.

3. The gate driver circuit according to any of the preceding claims,
wherein a controlled path of the junction transistor structure (300) is electrically connected between the high side part (200) and the low side part (100).

4. The gate driver circuit according to any of the preceding claims,
wherein the junction transistor structure (300) forms a p channel junction field effect transistor (310).

5. The gate driver circuit according to claim 4, further comprising:
a p-channel insulated gate field effect transistor (320) configured to receive a data signal and comprising a controlled path electrically connected in series with the controlled path of the p-channel junction field effect transistor (310).

6. The gate driver circuit according to any of claims 4 to 5,
wherein the p-channel junction field effect transistor (310) is formed in a semiconductor layer (430), the semiconductor layer (430) is formed on an insulator layer (420), and the insulator layer (420) is formed on a substrate (410) .

7. The gate driver circuit according to the preceding claim,
wherein the semiconductor layer (430) comprises a first layer portion (431) comprising the low side part (100), a second layer portion (432) comprising the high side part (200), and an intermediate layer portion (433) between the first layer portion (431) and the second layer portion (432), wherein the intermediate layer portion (433) comprises a semiconducting portion of the p-channel junction field effect transistor (310).

8. The gate driver circuit according to any of claims 4 to 7,
wherein the p-channel junction field effect transistor (310) comprises a p doped source region (311) formed at a side oriented to the high side part (200), a p doped drain region (312) formed at a side oriented to the low side part (100), one or more n+ doped gate regions (313) between the p doped source region (311) and the p doped drain region (312), and one or more p doped channel region (315) extending from the source region (311) to a p doped drain extension region (314) between the n+ doped gate regions (313) and the p doped drain region (312) .

9. The gate driver circuit according to the preceding claim,
wherein the p-channel junction field effect transistor (310) comprises one or more n doped compensation regions (316), wherein each n doped compensation region (316) extends from one of the gate regions (313) in direction of the drain region (312), and wherein a mean net dopant concentration in the n doped compensation regions (316) is at most half of the mean net dopant concentration in the n+ doped gate regions (313).

10. The gate driver circuit according to any of claims 8 and 9, further comprising:
an n+ emitter region (319) directly adjacent to the p doped drain region (312) on a side opposite the n+ gate regions (313), wherein a difference between a net dopant concentration in the n+ emitter region (319) and a net dopant concentration in the drain region (312) is sufficiently high to trigger injection of electrons from the n+ emitter region (319) into the p doped drain region (312) when the p-channel junction field effect transistor (310) is turned on.

11. The gate driver circuit according to any of claims 4 to 10, further comprising:
a reverse diode (330) electrically connected in series with the p-channel junction field effect transistor (310) at a side of the low side part (100).

12. The gate driver circuit according to claim 7, further comprising:
a reverse diode (330) electrically connected in series with the p-channel junction field effect transistor (310), wherein the reverse diode (330) is formed in the intermediate layer portion (433) at a side oriented to the first layer portion (431).

13. The gate driver circuit according to the preceding claim,
wherein the reverse diode (330) comprises a p doped anode region (331) and an n doped cathode region (332), wherein the p doped anode region (331) is electrically connected to the p doped drain region (312), and wherein the p doped anode region (331) and the n doped cathode region (332) form a pn junction.

14. The gate driver circuit according to claim 10 and any of claims 11 and 12,
wherein the reverse diode (330) comprises a p doped anode region (331) and an n doped cathode region (332), wherein the p doped anode region (331) is electrically connected to the n+ emitter region (319) and the p doped anode region (331) and the n doped cathode region (332) form a pn junction.
